# FASCICULE DE BREVET EUROPEEN

(11) **EP 2 643 856 B1**
(45) Date de publication et mention de la délivrance du brevet: **06.04.2016**
(21) Numéro de dépôt: 11802491.8
(22) Date de dépôt: 21.11.2011
(51) Int. Cl.: H01L 31/18, H02S 40/44

(54) **PANNEAU SOLAIRE HYBRIDE**
HYBRID-SOLARPANEEL
HYBRID SOLAR PANEL

(30) Priorité: 22.11.2010 FR 1059597
(43) Date de publication de la demande: 02.10.2013
(60) Demande divisionnaire: 16150504.5
(73) Titulaire: Solaire 2G, 13790 Rousset (FR)
(72) Inventeur: BROTTIER, Laetitia, 92240 Malakoff (FR); MOUTERDE, Jérôme, F-13006 Marseille (FR)
(74) Mandataire: Roman, Alexis
(86) Numéro de dépôt international: PCT/FR2011/052718
(87) Numéro de publication internationale: WO 2012/069750

(56) Documents cités:
- EP-A1- 0 460 872
- EP-A1- 1 310 747
- EP-A2- 0 981 167
- DE-A1- 3 611 543
- DE-A1- 10 344 084
- FR-A1- 2 911 997
- US-A- 4 361 717
- US-A- 5 935 343
- US-A1- 2005 161 074
- US-A1- 2008 302 405
- US-B1- 6 201 179

## Description

### Domaine technique de l'invention.

L'invention a pour objet un panneau solaire hybride. L'invention concerne également un procédé pour refroidir les éléments photovoltaïque d'un panneau solaire hybride ainsi qu'un procédé de fabrication d'un tel panneau solaire.

Elle concerne le domaine technique des échangeurs thermique pour le contrôle thermique de panneaux solaires hybrides (capables de produire une énergie électrique et une énergie thermique), lesdits échangeurs comprenant des moyens pour perturber l'écoulement du fluide de refroidissement.

### État de la technique.

Les panneaux solaires photovoltaïque permettent de produire une énergie électrique à partir du rayonnement solaire. Ils comprennent une pluralité d'éléments photovoltaïque (typiquement des cellules ou des couches minces) qui fonctionnent selon le principe de l'effet photoélectrique. Généralement, plusieurs éléments photovoltaïque sont reliées entre-deux sur un panneau solaire photovoltaïque, et plusieurs panneaux sont regroupés pour former une installation solaire. Cette installation produit de l'électricité qui peut être consommée sur place ou alimenter un réseau de distribution.

Les panneaux solaires photovoltaïque ne convertissent qu'une faible part du rayonnement solaire en électricité (aujourd'hui inférieure à 20%), le reste étant de la chaleur non utilisée. Cette chaleur est défavorable à la performance électrique des panneaux solaires puisqu'on peut constater une diminution de l'efficacité des éléments photovoltaïque avec la température d'environ -0,45%/°C. C'est pourquoi il est doublement intéressant de refroidir les panneaux solaires photovoltaïques. En effet, non seulement l'efficacité des éléments photovoltaïque croît, mais les calories du refroidissement peuvent être utilisées dans des systèmes de chauffage plus ou moins complexe. On parle alors de panneaux solaires hybrides capables de produire une énergie électrique et une énergie thermique.

Généralement un échangeur thermique est disposé en vis-à-vis de la face arrière des éléments photovoltaïque de façon à refroidir ces derniers. Les documents brevets suivants décrivent un certain nombre d'échangeurs thermiques pour panneaux solaires : FR 2.319.585 (LIEBARD) ; FR 2.566.183 (LUCCIONI) ; FR 2.727.790 (CYTHELIA) ; US 4.361.717 (GILMORE) ; US 4.184.543 (KLEINE) ; US 7.076.965 (LASICH) ; DE 197.47.325 (SCHRENK) ou DE 10.2004.002.900 (MASCHKE).

Tous ces échangeurs permettent de refroidir les éléments photovoltaïques afin d'accroitre leur rendement. Toutefois, ils présentent un certains nombre d'inconvénients : leur conception peut être relativement complexe et alourdissent les panneaux, ils ne permettent pas de refroidir de manière uniforme les éléments photovoltaïques, les calories ne sont pas extraites de manière optimisée, il est nécessaire d'utiliser beaucoup d'énergie pour déplacer le fluide réfrigérant, etc.

On connait plus particulièrement par le document brevet FR 2.911.997 (DIEMUNSCH), un panneau solaire hybride dans lequel l'échangeur thermique comporte une plaque de fond disposée sous les éléments photovoltaïque et sur laquelle s'écoule un fluide de refroidissement, avec un régime d'écoulement laminaire. Des éléments permettant de perturber l'écoulement du fluide de refroidissement sont disposés sur la plaque de fond de manière à favoriser les échanges thermiques. Les éléments de perturbation peuvent être des nervures orientées dans le sens de l'écoulement, des obstacles cylindriques ou sphériques permettant la création de tourbillons tridimensionnels de type Von Karman, des ailettes dont la hauteur est inférieure à l'épaisseur de l'écoulement pour créer des tourbillons de bords de pales, ou encore des roues à aubes introduites dans la lame de fluide de manière perpendiculaire à l'écoulement.

Ces différents éléments de perturbation sont tous rapportés sur la plaque de fond. Il donc nécessaire de les fixer par collage, soudage ou vissage, étapes qui complexifient la conception et qui sont couteuses en temps. Les coûts pour fabriquer un tel échangeur thermique de façon industrielle, c'est-à-dire en grande quantité, sont donc relativement élevés.

Face à cet état des choses, le principal objectif de l'invention est de simplifier la conception des échangeurs pour panneaux solaires hybrides, de façon à ce qu'ils puissent être fabriqués de façon industrielle, plus rapidement et à moindre coûts.

Parmi les autres objectifs à atteindre par l'invention on peut citer : une uniformité de la température au niveau des éléments photovoltaïques, une extraction optimisée des calories, une robustesse du panneau solaire tout en limitant son poids.

### Divulgation de l'invention.

La solution proposée par l'invention est un panneau solaire hybride selon la revendication indépendante 1.

Ce panneau est remarquable :
- en ce que la plaque inférieure est conformée de façon à former des éléments de perturbation intégrés s'étendant sur toute l'épaisseur de la lame dudit fluide de refroidissement s'écoulant dans la zone d'échange. Cette dernière intègre donc, dès sa fabrication, les éléments de perturbations, ce qui simplifie considérablement la fabrication de l'échangeur,
- et en ce que l'extrémité supérieure des éléments de perturbation est en contact avec la face arrière des éléments photovoltaïques de manière à ce que lesdits éléments photovoltaïque soient principalement refroidis au niveau de ces points de contact.

Dans une variante de réalisation selon la revendication indépendante 2, une plaque d'échange supérieure, avantageusement à base d'aluminium, est fixée sur la face arrière des éléments photovoltaïques, l'extrémité supérieure des éléments de perturbation étant en contact avec ladite plaque supérieure de manière à ce que la température de cette dernière est homogène sans points froids ou chauds.

Quelle que soit la solution retenue, le résultat technique est identique. En effet, le contact thermique entre les éléments de perturbation et la face arrière des éléments photovoltaïque (ou la plaque d'échange supérieure), assure une transmission efficace de la chaleur vers la plaque inférieure ce qui n'est pas possible avec le panneau décrit dans le document brevet FR 2.911.997 précité. La plaque inférieure peut donc extraire efficacement des calories issues des éléments photovoltaïque qui sont ensuite évacuées par le fluide de refroidissement. Ce dernier récupère donc les calories non seulement au niveau de la face arrière des éléments photovoltaïques, mais également au niveau de la plaque inférieure.

Les éléments de perturbation forment préférentiellement des bosses au niveau de la face supérieure de la plaque inférieure sur laquelle s'écoule le fluide de refroidissement et forment des creux au niveau de la face inférieure de ladite plaque qui n'est pas en contact avec ledit fluide et qui est opposée à ladite face supérieure.

La plaque inférieure est avantageusement métallique et emboutie de façon à former les éléments de perturbation.

Préférentiellement, l'échangeur thermique est une pièce monobloc, la plaque inférieure étant conformée de façon à constituer non seulement la zone d'échange, mais également une zone d'arrivée et une zone d'évacuation du fluide de refroidissement.

La plaque inférieure peut être conformée de façon à constituer non seulement la zone d'échange de l'échangeur thermique, mais également tout ou partie du support sur lequel reposent les éléments photovoltaïques.

L'échangeur thermique comprend préférentiellement des canaux de circulation du fluide de refroidissement disposés de part et d'autre de la zone d'échange, lesdits canaux ayant des pertes de charge assurant une répartition homogène dudit fluide dans ladite zone d'échange. La plaque inférieure peut être conformée de façon à former ces canaux de distribution.

Pour optimiser l'homogénéisation du fluide de refroidissement dans la zone d'échange, la profondeur des canaux de circulation est préférentiellement supérieure à l'épaisseur de lame dudit fluide s'écoulant dans ladite zone d'échange. De manière plus générale, les pertes de charges générées dans les canaux de circulation sont négligeables par rapport à celles induites dans la zone d'échange.

La face arrière de l'échangeur peut être dépourvue de tout moyen d'isolation thermique.

Selon une autre caractéristique de l'invention, un boitier de jonction fin et long est disposé sur la face arrière dudit panneau, préférentiellement contre une bordure arrière dudit panneau, et de manière plus générale sans être en vis-à-vis de la face arrière d'un élément photovoltaïques. Cette caractéristique est techniquement indépendante des autres caractéristiques décrites précédemment et notamment de la conception de l'échangeur.

Un autre aspect de l'invention concerne un procédé pour refroidir les éléments photovoltaïque d'un panneau solaire hybride, consistant à :
- faire circuler un fluide de refroidissement dans une zone d'échange thermique disposée sous lesdits éléments photovoltaïque de façon à les refroidir,
- perturber l'écoulement dudit fluide dans ladite zone d'échange,

Ce procédé est remarquable en ce qu'on perturbe le fluide de refroidissement en intégrant dans la zone d'échange, des éléments de perturbation obtenus par la conformation d'une plaque d'échange inférieure, lesdits éléments s'étendant sur toute l'épaisseur de la lame dudit fluide s'écoulant dans ladite zone d'échange.

Encore un autre aspect de l'invention concerne un procédé de fabrication d'un panneau solaire hybride dans lequel un échangeur thermique est disposé sous les éléments photovoltaïque dudit panneau, ledit procédé consistant à :
- disposer une plaque d'échange inférieure sous lesdits éléments photovoltaïques, et sur laquelle est destinée à s'écouler un fluide de refroidissement, ladite plaque formant une zone d'échange thermique présentant des éléments permettant de perturber l'écoulement dudit fluide,
- conformer ladite plaque inférieure de façon à former des éléments de perturbation intégrés susceptibles de s'étendre sur toute l'épaisseur de la lame dudit fluide s'écoulant dans ladite zone d'échange.

Préférentiellement, on utilise une plaque inférieure métallique que l'on emboutie de façon à former les éléments de perturbation.

### Description des figures.

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs et sur lesquels :
- la figure 1 est une vue schématique en coupe d'un panneau solaire hybride conforme à l'invention,
- la figure 2 est une vue agrandie du détail D1 de la figure 1,
- la figure 3 est une vue schématique en coupe d'un panneau solaire hybride conforme à l'invention, dans une variante de réalisation,
- la figure 4 est une vue agrandie du détail D2 de la figure 3,
- la figure 5 est une vue en coupe selon A-A du panneau de la figure 1, les éléments de perturbations étant arrangés de manière linéaire,
- la figure 6 représente le panneau de la figure 5 dans une variante de réalisation, les éléments de perturbations étant arrangés en quinconce,
- la figure 7 est représente, en perspective, une plaque inférieure d'échange conforme à l'invention,
- la figure 8 est une vue de dessus d'un panneau solaire équipé d'un un boitier de jonction EDGE,
- la figure 9 est une vue de dessous du panneau solaire de la figure 6,
- les figures 10a à 10c schématise différentes de fabrication d'un échangeur monobloc conforme à l'invention.

### Modes de réalisation de l'invention.

Le panneau solaire objet de l'invention est un panneau hybride, c'est-à-dire qu'il est capable de produire une énergie électrique et une énergie thermique. Il est destiné à être utilisé seul ou en combinaison avec d'autre panneaux similaires, de façon à ce que l'énergie électrique et thermique qu'elle produit soient exploitables par une habitation ou une installation.

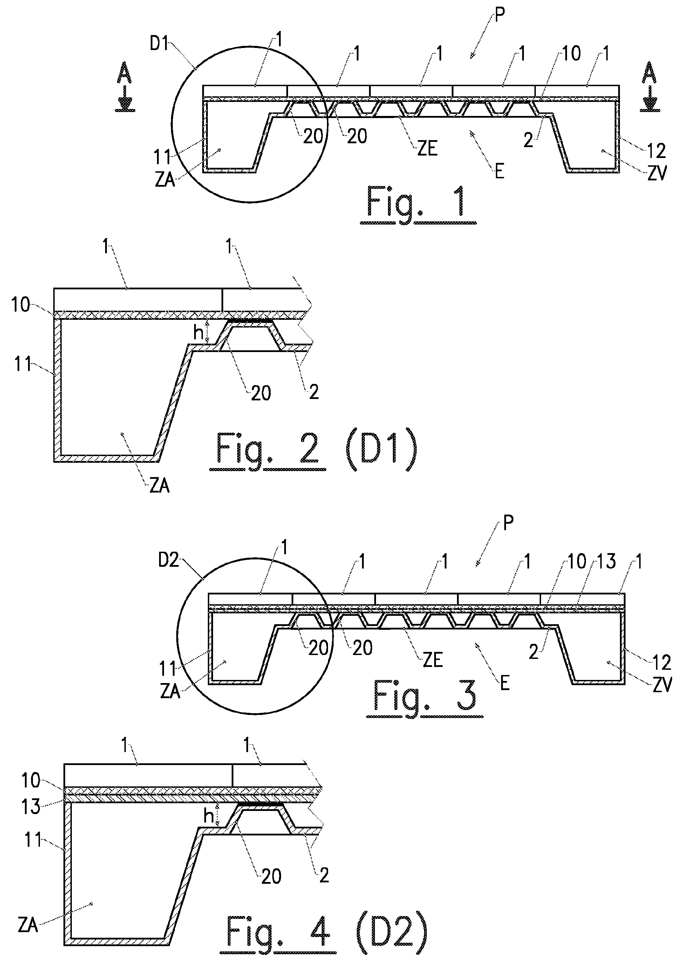

En se rapportant aux figures 1 à 4, le panneau solaire P intègre des éléments photovoltaïque 1 comportant une face avant et une face arrière. La face avant est laissée libre de façon à ce qu'elle puisse recevoir le rayonnement solaire. La face arrière est en vis-à-vis d'un échangeur thermique E. Le panneau solaire P comporte plusieurs éléments photovoltaïque 1 connectés en série ou en parallèle. Ces derniers peuvent contenir des cellules photovoltaïques, des couches minces photovoltaïques, etc. Les types d'éléments photovoltaïque susceptibles d'être employés étant bien connus de l'homme du métier, ils ne seront pas détaillés ici avec plus de précision.

En pratique, les éléments photovoltaïque 1 reposent sur l'échangeur E qui fait office de support. Ils peuvent être fixés directement sur ce dernier, ou être d'abords fixé à un cadre rigide qui peut être lui-même fixé audit échangeur. En cas de présence d'un cadre, il n'est toutefois pas nécessaire qu'il y ait fixation de l'échangeur à ce cadre, en effet, il suffit que ce dernier soit disposé sous les éléments photovoltaïques, sans assurer de fonction support. Dans tous les cas, l'échangeur E est situé sous les éléments photovoltaïque 1 de manière à ne pas faire obstacle au rayonnement solaire.

Un fluide de refroidissement, qui est typiquement de l'eau glycolée, circule dans l'échangeur E afin de récupérer les calories issues des éléments photovoltaïques 1. Pour protéger électriquement les éléments photovoltaïques, 1 du fluide de refroidissement, un isolant électrique étanche 10 fait l'interface avec la face arrière desdits éléments. Il n'y a donc pas de contact direct entre les composants électriques des éléments photovoltaïques 1 et le fluide de refroidissement. Cet isolant 10 peut consister en une feuille (plus connue sous terme anglais « backsheet ») pré-collée aux éléments photovoltaïque 1, ou un colle isolante électrique (par exemple du type gel silicone). Au sens de présente invention, la « face arrière » des éléments photovoltaïque s'entend comme étant isolée électriquement par l'isolant électrique étanche 10 et/ou par la plaque supérieure 13 décrite plus après. La face arrière des éléments photovoltaïques 1 est donc isolée électriquement.

En pratique, l'échangeur E comprend trois zones principales : une zone d'arrivée ZA du fluide de refroidissement, une zone d'échange thermique ZE et une zone d'évacuation ZV dudit fluide. Les éléments photovoltaïque 1 sont préférentiellement regroupés au-dessus de la zone d'échange ZE mais peuvent être répartis au-dessus des zones d'arrivée ZA et d'évacuation ZV. La zone d'échange ZE a par exemple une surface comprise entre 0,5 m² et 4 m².

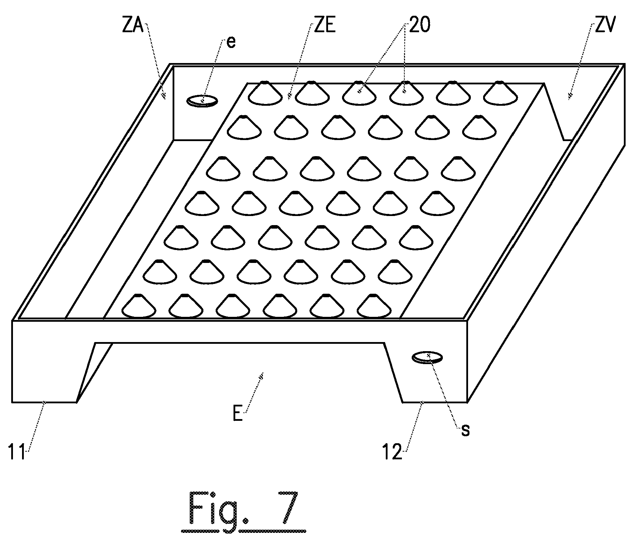

Comme représenté sur la figure 7, l'échangeur E est préférentiellement une pièce monobloc, obtenue par l'emboutissage d'une plaque métallique, par moulage ou autre. La configuration de cette pièce monobloc délimite non seulement la zone d'échange ZE mais également les zones d'arrivée ZA et d'évacuation ZV.

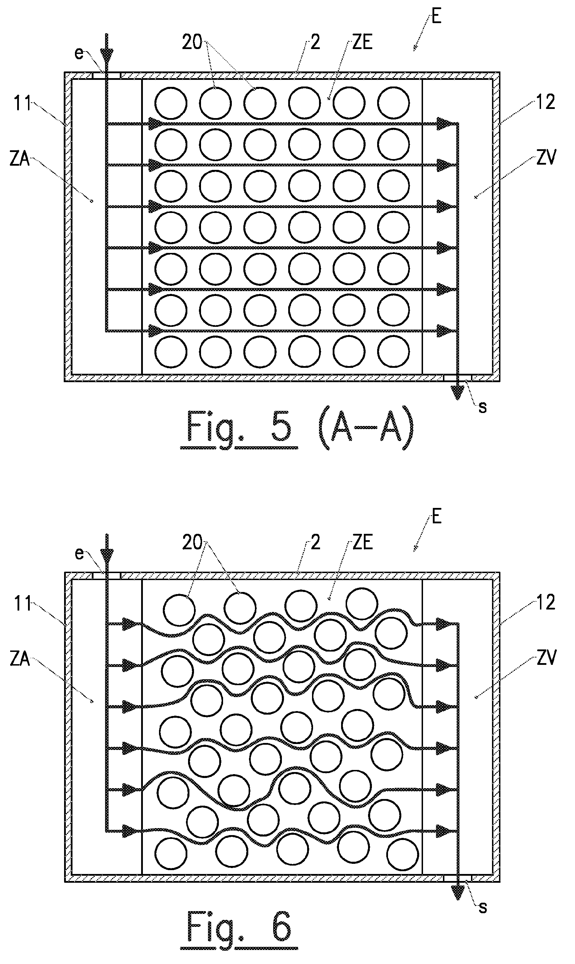

En se rapportant aux figures 1 à 9, les zones d'arrivée ZA et d'évacuation ZV sont formées par des canaux de circulation 11, 12 disposés de part et d'autre de la zone d'échange ZE. Ces canaux 11, 12 ont la forme de gouttières communiquant, par leur bords longitudinaux, avec la zone d'échange ZE. Ils sont parallèles entre eux et sont orientés perpendiculairement au sens d'écoulement du fluide dans la zone d'échange ZE. Sur les figures 5 à 6, l'entrée e et la sortie s du fluide dans l'échangeur E sont prioritairement diagonalement opposées mais peuvent être disposées symétriquement, au même niveau. L'entrée e et la sortie s peuvent être situées dans le fond des canaux de circulation 11, 12 ou être réalisées sur les parois latérales de ces derniers. Les canaux 11, 12, peuvent avoir une section rectangulaire, carrée, trapézoïdale, ronde ou autre, et ont des pertes de charge négligeables par rapport aux pertes de charges de la zone d'échange ZE. En pratique, la profondeur des canaux de circulation 11, 12 est supérieure à l'épaisseur de lame du fluide s'écoulant dans la zone d'échange ZE. Cette quasi-absence de pertes de charge sur les côtés de l'échangeur E joue un rôle de distributeur. En effet, le fluide remplit d'abord intégralement le canal d'arrivée 11 avant de se répandre de manière homogène dans la zone d'échange ZE. Le fluide sort de cette dernière et s'écoule dans le canal de sortie 12, sans trouver d'obstacle. On évite ainsi l'apparition de chemins privilégiés pour le fluide de refroidissement, et on élimine les points chauds sous les éléments photovoltaïques 1.

La zone d'échange thermique ZE est formée par une plaque d'échange inférieure 2 disposée sous les éléments photovoltaïques 1 et sur laquelle s'écoule le fluide de refroidissement. Conformément à l'invention, la plaque inférieure 2 est conformée de façon à former des éléments de perturbation 20. La plaque 2 intègre donc, dès sa fabrication, ces éléments de perturbation 20 qui sont réalisés dans le même matériau que ladite plaque. Ces derniers ont une double fonction :
- perturber l'écoulement du fluide de refroidissement de façon à favoriser les échanges thermique dans la zone d'échange ZE,
- augmenter la surface d'échange thermique et donc participer à l'échange thermique.

En pratique, les éléments de perturbation 20 peuvent avoir la forme de nervures, de mamelons, de demi-sphère, de tubes cylindriques ou polygonaux, de pyramides, etc. Selon la surface de la zone d'échange ZE, le nombre d'éléments de perturbation 20 peut varier de quelque dizaine à plusieurs centaines. On peut par exemple prévoir une ou plusieurs centaines d'éléments de perturbation 20 par m² de surface d'échange. On peut par exemple prévoir 300 éléments de perturbation par m². Ils peuvent être répartis de manière régulière, et plus précisément de manière linéaire, formant des chemins d'écoulement parallèles, comme représentés sur la figure 5. Dans ce cas, l'écoulement du fluide de refroidissement est globalement parallèle, mais localement perturbé au niveau des éléments 20. Dans une variante de réalisation représentée sur la figure 6, les éléments de perturbation 20 peuvent être répartis de manière irrégulières, et notamment en quinconce. Dans ce cas, l'écoulement du fluide de refroidissement est perturbé sans être forcément parallèle.

Les éléments de perturbation 20 s'étendent sur toute l'épaisseur de la lame de fluide s'écoulant dans la zone d'échange ZE. En se rapportant plus particulièrement aux figures 2 et 4, la hauteur « h » des éléments de perturbation 20 correspond à l'épaisseur de la lame de fluide s'écoulant dans la zone d'échange ZE. Il n'y a donc pas de lame de fluide qui puisse passer au-dessus des éléments de perturbation 20. En pratique, l'épaisseur de la lame de fluide dans la zone d'échange ZE (et la hauteur « h » des éléments de perturbation 20) est de quelques millimètres.

On privilégie une plaque 2 en aluminium, ou en alliages d'aluminium, de façon à obtenir un bon compromis poids/prix/conductivité thermique. Toutefois, d'autres métaux (cuivre; zinc; fonte; ...) ou d'autres matériaux (carbone; thermoplastiques tels que polyacéthylène, polyaniline, polypyrrole ; polymères chargés de poudres ou paillettes métalliques; ...) conducteurs de chaleur et convenant à l'homme du métier peuvent être employés. En pratique, on utilise une plaque 2 métallique qui est emboutie de façon à former les éléments de perturbation 20. En se rapportant aux figures 1 à 4, il apparait clairement que les éléments de perturbation 20 forment des bosses au niveau de la face supérieure de la plaque 2 sur laquelle s'écoule le fluide de refroidissement et forment des creux au niveau de la face inférieure de ladite plaque qui n'est pas en contact avec ledit fluide et qui est opposée à ladite face supérieure. Ces creux augmentent la surface d'échange thermique entre la plaque 2 et l'air circulant sous la zone d'échange ZE.

En se rapportant au mode de réalisation des figures 1 et 2, l'extrémité supérieure des éléments de perturbation 20 est directement en contact avec la face arrière des éléments photovoltaïque 1. L'extrémité supérieure des éléments de perturbation 20 est par exemple collée à l'isolant 10. Les éléments photovoltaïques 1 sont donc principalement refroidis au niveau de ces points de contact. L'extrémité supérieure des éléments de perturbation 20 est conformée de manière à assurer un contact surfacique avec la face arrière des éléments photovoltaïques 1. Cette surface de contact est avantageusement comprise entre 1 mm² et 10 cm², préférentiellement environ 3 mm², préférentiellement encore environ 4,5 mm². Ce contact surfacique entre l'extrémité supérieure des éléments de perturbation et la face arrière des éléments photovoltaïque 1, assure une transmission efficace de la chaleur vers la plaque inférieure 2. Le fluide de refroidissement récupère donc la chaleur non seulement au niveau de la face arrière des éléments photovoltaïques 1, mais également au niveau de la plaque inférieure 2, ce qui augmente considérablement les échanges thermiques et optimise le refroidissement desdits éléments photovoltaïques.

Dans une variante de réalisation représentée sur les figures 3 et 4, une plaque d'échange supérieure 13 est fixée sur la face arrière des éléments photovoltaïques 1. Comme pour la plaque inférieure 2, on privilégie une plaque supérieure 13 en aluminium, ou en alliages d'aluminium. D'autres matériaux conducteurs de chaleur du type décrits précédemment et convenant à l'homme du métier peuvent toutefois être employés.

L'extrémité supérieure des éléments de perturbation 20 est conformée de manière à assurer un contact surfacique avec cette plaque supérieure 13. Cette surface de contact est avantageusement comprise entre 1 mm² et 10 cm², préférentiellement environ 3 mm², préférentiellement encore environ 4,5 mm². La plaque supérieure 13 est par exemple collée ou soudée aux extrémités des éléments de perturbation 20 et/ou sur les bordures de l'échangeur E.

Plusieurs solutions permettent d'assembler la plaque supérieure 13 et les éléments photovoltaïque 1. La plaque 13 peut par exemple être collée sous une feuille isolante pré-collée sur la face arrière des éléments photovoltaïques 1. On peut également fixer la plaque 13 sur la face arrière des éléments photovoltaïques 1 en utilisant une colle isolante électrique (par ex : gel silicone). Il est encore possible de revêtir d'un film isolant la plaque 13 et de faire le vide entre ladite plaque et une plaque de verre/plastique rigidifiant, les éléments photovoltaïques étant disposés entre les deux dites plaques. La plaque 13 se retrouve plaquée à la plaque de verre/plastique par l'aspiration du vide, les éléments photovoltaïque étant pris en sandwich. En tout état de cause, quelle que soit la technique de fixation employée, la plaque 13 assure une fonction d'étanchéité au fluide de refroidissement.

La plaque inférieure 2 a tendance à être plus froide que la plaque supérieure 13, car les éléments de perturbation 20 permettent de bien la refroidir. L'extrémité supérieure des éléments de perturbations 20 assure un bon contact thermique avec la plaque supérieure 13. Ce contact surfacique entre l'extrémité supérieure des éléments de perturbation 20 et la plaque supérieure 13, assure une transmission efficace de la chaleur vers la plaque inférieure 2. Le fluide de refroidissement récupère donc la chaleur non seulement au niveau de la plaque supérieure 13, mais également au niveau de la plaque inférieure 2, ce qui augmente considérablement les échanges thermiques et optimise le refroidissement desdits éléments photovoltaïques. Du fait de sa bonne conductivité thermique, la température de la plaque supérieure 13 s'homogénéise rapidement, ladite plaque se refroidissant entièrement, sans garder de points froids ou chauds (alors que dans l'exemple des figures 1 et 2, le refroidissement intervenait localement au niveau des extrémités supérieures des éléments de perturbation 20). L'intérêt principal d'obtenir une température homogène sur la plaque supérieure 13, est que les éléments photovoltaïque 1 vont être refroidis de manière homogène, donc sans point chaud. L'efficacité du panneau est donc augmentée, étant rappelé que les éléments photovoltaïques 1 fixent leur production électrique sur l'élément le plus faible, c'est-à-dire le plus chaud.

Conformément à l'invention, la plaque 2 est conformée de façon à ce qu'elle intègre directement les éléments de perturbation 20. La plaque 2 peut également être conformée de façon à constituer tout ou partie du support sur lesquelles reposent les éléments photovoltaïque 1. Son encombrement et son poids étant ainsi réduit, l'échangeur E n'en reste pas moins d'avantage structurant pour le panneau que les échangeurs connus de l'art antérieur. La plaque 2 peut être également être conformée pour former les canaux de distribution 11, 12 (figure 7). Dans ce cas, l'échangeur E est monobloc, formé d'une seule pièce définissant la zone d'arrivée ZA du fluide de refroidissement, la zone d'échange thermique ZE avec éléments de perturbation intégrés et la zone d'évacuation ZV dudit fluide. On peut toutefois prévoir de fixer d'autres pièces à la plaque 2 pour la renforcer. Mais dans tous les cas, le nombre de pièces constitutives de l'échangeur E est réduit par rapport aux échangeurs connus de l'art antérieur.

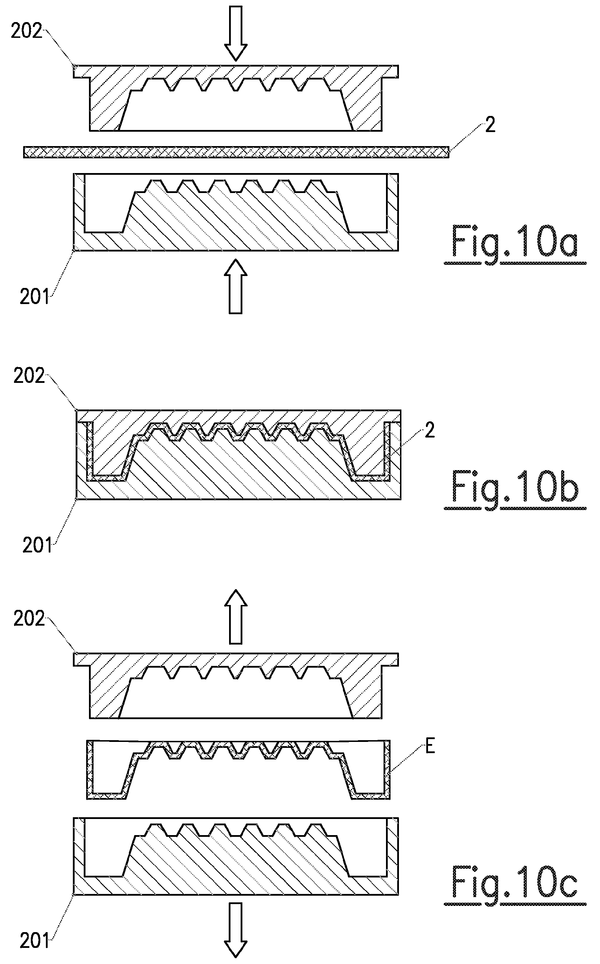

Les figures 10a à 10c schématisent les différentes étapes de fabrication d'un échangeur monobloc intégrant non seulement les éléments de perturbation mais également les canaux latéraux de circulation. La technique illustrée est l'emboutissage (ou le matriçage). Une plaque 2 métallique est disposée au regard d'une matrice 201 et d'un poinçon 202 (figure 10a). La matrice 201 et le poinçon 202 présentent des empreintes complémentaires dont la géométrie correspond à la pièce à réaliser. En pénétrant dans la matrice 201, le poinçon 202 va déformer la plaque 2 pour la conformer à la géométrie voulue (figure 10b). Il suffit alors de séparer le poinçon 202 de la matrice 201 de façon à obtenir l'échangeur E. Le procédé de fabrication étant très simple et très rapide, ce type d'échangeur peut être facilement industrialisé.

Il serait également possible d'obtenir un échangeur monobloc avec d'autres techniques de fabrication telles que le moulage, dans le cas où le matériau utilisé est du type fonte, thermoplastiques ou polymères chargés.

Les panneaux solaires photovoltaïque utilisent généralement des boîtes de jonction pour loger les diodes by-pass. Ces boîtes ont généralement une forme rectangulaire et sont fixés sur la face arrière du panneau. Compte tenu de l'encombrement de ces boîtes, les panneaux hybrides doivent contourner, par leur géométrie, lesdites boîtes en prévoyant un logement dans l'échangeur. Au niveau de ce logement pour boîte de jonction, l'échange de chaleur est perturbé, voire diminuer, de sorte que les éléments photovoltaïques situés juste au dessus ne sont pas refroidies de manière optimale. Cela affecte le rendement du panneau étant donné que c'est toujours sur l'élément photovoltaïque le plus chaud, donc la plus faible, que s'aligne l'ensemble du panneau.

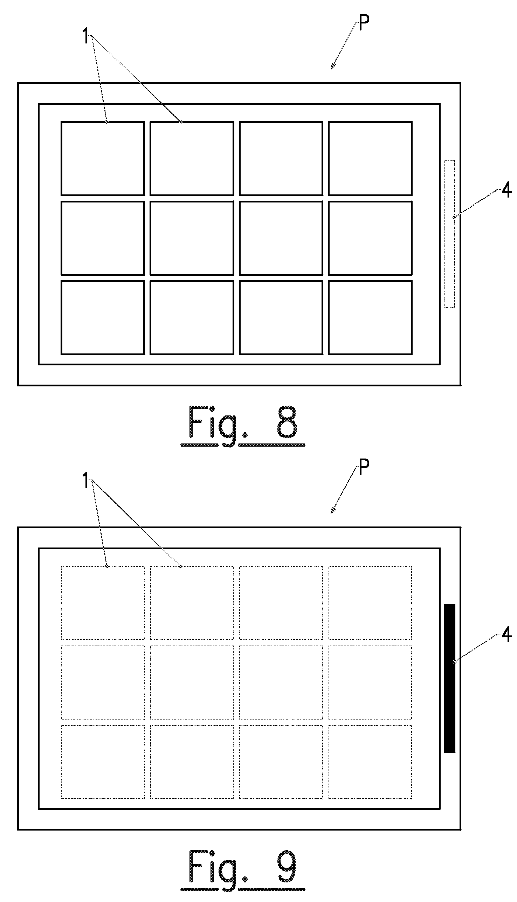

Pour résoudre ce problème, on utilise des boîtiers de jonction fins et longs, par exemple du type boîtiers décentralisés TYCO® ou boîtiers EDGE. En pratique, le boîtier utilisé a une longueur d'environ 130 mm, une largeur d'environ 12 mm et une hauteur d'environ 12 mm. En se rapportant aux figures 8 et 9, ce boitier de jonction 4 est disposé sur la face arrière du panneau P, préférentiellement contre une bordure arrière dudit panneau, et de manière plus générale sans être en vis-à-vis de la face arrière d'un élément photovoltaïques 1. La finesse d'un tel boîtier permet d'être entièrement « au-dessus » de la première rangée d'éléments photovoltaïque 1, ces derniers étant donc tous refroidis de manière homogène.

## Revendications

1. Panneau solaire hybride comprenant :
- des éléments photovoltaïques (1) comportant une face avant et une face arrière,
- un échangeur thermique (E) disposé en vis-à-vis de la face arrière desdits éléments photovoltaïques (1),
- un fluide de refroidissement circulant dans ledit échangeur (E) de manière à refroidir lesdits éléments photovoltaïques (1),
- ledit échangeur (E) comportant une zone d'échange thermique (ZE) disposée sous lesdits éléments photovoltaïques (1) et dans laquelle s'écoule ledit fluide, ladite zone d'échange est formée par une plaque inférieure (2) présentant des éléments (20) permettant de perturber l'écoulement dudit fluide de façon à favoriser les échanges thermique dans la zone d'échange (ZE),
- lesdits éléments de perturbation (20) intégrés s'étendent sur toute l'épaisseur de la lame du fluide de refroidissement s'écoulant dans ladite zone d'échange,
**se caractérisant par le fait que** :
- la plaque inférieure (2) est une plaque d'échange thermique réalisée dans un matériau conducteur de chaleur et conformée de façon à former, dès la fabrication de ladite plaque, les éléments de perturbation (20), lesquels éléments sont réalisés dans le même matériau que ladite plaque,
- l'extrémité supérieure des éléments de perturbation (20) est en contact surfacique avec la face arrière des éléments photovoltaïque (1), le contact surfacique entre l'extrémité supérieure des éléments de perturbation (20) et la face arrière des éléments photovoltaïques (1) assure une transmission de la chaleur vers la plaque inférieure (2) de manière à ce que le fluide de refroidissement récupère la chaleur issue des éléments photovoltaïques (1) non seulement au niveau de la face arrière desdits éléments photovoltaïques, mais également au niveau de la plaque inférieure (2) pour que lesdits éléments photovoltaïques soient principalement refroidis au niveau de ces points de contact,
- les éléments de perturbation (20) forment des bosses au niveau de la face supérieure de la plaque (2) sur laquelle s'écoule le fluide de refroidissement et forment des creux au niveau de la face inférieure de ladite plaque qui n'est pas en contact avec ledit fluide et qui est opposée à ladite face supérieure.

2. Panneau solaire hybride comprenant :
- des éléments photovoltaïques (1) comportant une face avant et une face arrière,
- un échangeur thermique (E) disposé en vis-à-vis de la face arrière desdits éléments photovoltaïques (1),
- un fluide de refroidissement circulant dans ledit échangeur (E) de manière à refroidir lesdits éléments photovoltaïques (1),
- ledit échangeur (E) comportant une zone d'échange thermique (ZE) disposée sous lesdits éléments photovoltaïques (1) et dans laquelle s'écoule ledit fluide, ladite zone d'échange est formée par une plaque inférieure (2) présentant des éléments (20) permettant de perturber l'écoulement dudit fluide de façon à favoriser les échanges thermique dans la zone d'échange (ZE),
- une plaque d'échange supérieure (13) est fixée sur la face arrière des éléments photovoltaïque (1),
- les éléments de perturbation (20) intégrés s'étendent sur toute l'épaisseur de la lame du fluide de refroidissement s'écoulant dans ladite zone d'échange, leur extrémité supérieure étant en contact surfacique avec la plaque d'échange supérieure (13),
**se caractérisant par le fait que** :
- la plaque inférieure (2) est une plaque d'échange thermique réalisée dans un matériau conducteur de chaleur et conformée de façon à former, dès la fabrication de ladite plaque, les éléments de perturbation (20), lesquels éléments sont réalisés dans le même matériau que ladite plaque,
- le contact surfacique entre l'extrémité supérieure des éléments de perturbation (20) et la plaque supérieure (13) assure une transmission de la chaleur vers la plaque inférieure (2) de sorte que le fluide de refroidissement récupère la chaleur issue des éléments photovoltaïques non seulement au niveau de la plaque supérieure (13) mais également au niveau de la plaque inférieure (2), de manière à ce que la température de ladite plaque supérieure (13) s'homogénéise sans points froids ou chauds,
- les éléments de perturbation (20) forment des bosses au niveau de la face supérieure de la plaque (2) sur laquelle s'écoule le fluide de refroidissement et forment des creux au niveau de la face inférieure de ladite plaque qui n'est pas en contact avec ledit fluide et qui est opposée à ladite face supérieure.

3. Panneau solaire selon l'une des revendications précédentes, **dans lequel** les éléments de perturbation (20) ont la forme de mamelons.

4. Panneau solaire selon l'une des revendications précédentes, **dans lequel** les éléments de perturbation (20) ont la forme de demi-sphères.

5. Panneau solaire selon l'une des revendications précédentes, **dans lequel** les éléments de perturbation (20) ont la forme de tubes cylindriques ou de tubes polygonaux, ou la forme de pyramides.

6. Panneau solaire l'une des revendications précédentes, comportant plusieurs centaines d'éléments de perturbation (20) par m² de surface d'échange.

7. Panneau solaire selon l'une des revendications précédentes, **dans lequel** les éléments de perturbation (20) sont répartis de manière irrégulière, notamment en quinconce.

8. Panneau solaire selon l'une des revendications précédentes, **dans lequel** la plaque inférieure (2) est métallique et emboutie de façon à former les éléments de perturbation (20).

9. Panneau solaire selon l'une des revendications précédentes, **dans lequel** l'échanger thermique (E) est une pièce monobloc, la plaque inférieure (2) étant conformée de façon à constituer non seulement la zone d'échange (ZE), mais également une zone d'arrivée (ZA) et une zone d'évacuation (ZV) du fluide de refroidissement.

10. Panneau solaire selon l'une des revendications précédentes, **dans lequel** la plaque inférieure (2) est conformée de façon à constituer non seulement la zone d'échange (ZE), mais également tout ou partie du support sur lesquelles reposent les éléments photovoltaïques (1).

11. Panneau solaire selon l'une des revendications précédentes, **dans lequel** l'échangeur thermique (E) comprend des canaux de circulation (11, 12) du fluide de refroidissement disposés de part et d'autre de la zone d'échange (ZE), lesdits canaux ayant des pertes de charge assurant une répartition homogène dudit fluide dans ladite zone d'échange.

12. Panneau selon la revendication 11, **dans lequel** la profondeur des canaux de circulation (11, 12) est supérieure à l'épaisseur de lame du fluide de refroidissement s'écoulant dans la zone d'échange (ZE).

13. Panneau solaire selon l'une des revendications 11 ou 12, **dans lequel** la plaque inférieure (2) est conformée de façon à former les canaux de circulation (11, 12).

14. Panneau solaire selon l'une des revendications précédentes, **dans lequel** la face arrière de l'échangeur thermique (E) est dépourvue de moyen d'isolation thermique.

15. Panneau solaire selon l'une des revendications précédentes, **dans lequel** un boitier de jonction fin et long (4) est disposé sur la face arrière dudit panneau, sans être en vis-à-vis de la face arrière d'un élément photovoltaïque (1).

## Patentansprüche

1. Hybrid-Solarpaneel, das Folgendes umfasst:
- fotovoltaische Elemente (1), die eine Vorderseite und eine Rückseite umfassen,
- einen Wärmeaustauscher (E), der gegenüber der Rückseite der fotovoltaischen Elemente (1) angeordnet ist,
- ein Kühlmittel, das in dem Wärmeaustauscher (E) derart zirkuliert, dass die fotovoltaischen Elemente (1) gekühlt werden,
- wobei der Wärmeaustauscher (E) eine Wärmeaustauschzone (ZE) umfasst, die unter den fotovoltaischen Elementen (1) angeordnet ist, und in der das Fluid fließt, wobei die Austauschzone durch eine untere Platte (2) ausgebildet ist, die Elemente (20) aufweist, die es erlauben, das Fließen des Fluids derart zu stören, dass die Wärmeaustausche in der Austauschzone (ZE) begünstigt werden,
- wobei sich die eingebauten Störungselemente (20) auf der gesamten Stärke der Kühlmittelzunge, die in der Austauschzone fließt, erstrecken, **dadurch gekennzeichnet, dass**
- die untere Platte (2) eine Wärmeaustauschplatte ist, die aus einem wärmeleitfähigen Werkstoff hergestellt und derart gestaltet ist, dass sie ab der Herstellung der Platte die Störungselemente (20) bildet, wobei die Elemente aus demselben Werkstoff wie die Platte hergestellt sind,
- wobei das obere Ende der Störungselemente (20) in Oberflächenberührung mit der Rückseite der fotovoltaischen Elemente (1) steht, wobei die Oberflächenberührung zwischen dem oberen Ende der Störungselemente (20) und der Rückseite der fotovoltaischen Elemente (1) eine Übertragung der Wärme zu der unteren Platte (2) derart sicherstellt, dass das Kühlmittel die Wärme, die aus den fotovoltaischen Elementen (1) stammt, nicht nur im Bereich der Rückseite der fotovoltaischen Elemente zurückgewinnt, sondern auch im Bereich der unteren Platte (2), damit die fotovoltaischen Elemente im Wesentlichen im Bereich dieser Berührungsstellen gekühlt werden,
- wobei die Störungselemente (20) Höcker im Bereich der Oberseite der Platte (2), auf der das Kühlmittel fließt, bilden, und Vertiefungen im Bereich der Unterseite der Platte, die nicht mit dem Fluid in Berührung ist und die der Oberseite entgegengesetzt ist, bilden.

2. Hybrid-Solarpaneel, das Folgendes umfasst:
- fotovoltaische Elemente (1), die eine Vorderseite und eine Rückseite umfassen,
- einen Wärmeaustauscher (E), der gegenüber der Rückseite der fotovoltaischen Elemente (1) angeordnet ist,
- ein Kühlmittel, das in dem Wärmeaustauscher (E) derart zirkuliert, dass die fotovoltaischen Elemente (1) gekühlt werden,
- wobei der Wärmeaustauscher (E) eine Wärmeaustauschzone (ZE) umfasst, die unter den fotovoltaischen Elementen (1) angeordnet ist, und in der das Fluid fließt, wobei die Austauschzone durch eine untere Platte (2) ausgebildet ist, die Elemente (20) aufweist, die es erlauben, das Fließen des Fluids derart zu stören, dass die Wärmeaustausche in der Austauschzone (ZE) begünstigt werden,
- eine obere Austauschplatte (13), die auf der Rückseite der fotovoltaischen Elemente (1) befestigt ist,
- wobei sich die eingebauten Störungselemente (20) auf der gesamten Stärke der Kühlmittelzunge, die in der Austauschzone fließt, erstrecken, wobei ihr oberes Ende in Oberflächenberührung mit der oberen Austauschplatte (13) ist,
**dadurch gekennzeichnet, dass**
- die untere Platte (2) eine Wärmeaustauschplatte ist, die aus einem wärmeleitfähigen Werkstoff hergestellt und derart gestaltet ist, dass sie ab der Herstellung der Platte die Störungselemente (20) bildet, wobei die Elemente aus demselben Werkstoff wie die Platte hergestellt sind,
- die Oberflächenberührung zwischen dem oberen Ende der Störungselemente (20) und der oberen Platte (13) eine Wärmeübertragung zu der unteren Platte (2) derart sicherstellt, dass das Kühlmittel die Wärme, die aus den fotovoltaischen Elementen stammt, nicht nur im Bereich der oberen Platte (13), sondern auch im Bereich der unteren Platte (2) derart zurückgewinnt, dass die Temperatur der oberen Platte (13) ohne kalte oder warme Stellen vereinheitlicht wird,
- wobei die Störungselemente (20) Höcker im Bereich der Oberseite der Platte (2), auf der das Kühlmittel fließt, bilden, und Vertiefungen im Bereich der Unterseite der Platte, die nicht mit dem Fluid in Berührung ist und der Oberseite entgegengesetzt ist, bilden.

3. Solarpaneel nach einem der vorhergehenden Ansprüche, wobei die Störungselemente (20) die Form von Noppen haben.

4. Solarpaneel nach einem der vorhergehenden Ansprüche, wobei die Störungselemente (20) die Form von Halbkugeln haben.

5. Solarpaneel nach einem der vorhergehenden Ansprüche, wobei die Störungselemente (20) die Form zylindrischer Röhren oder vieleckiger Röhren oder die Form von Pyramiden haben.

6. Solarpaneel einem der vorhergehenden Ansprüche, das mehrere Hundert Störungselemente (20) pro m² Austauschoberfläche umfasst.

7. Solarpaneel nach einem der vorhergehenden Ansprüche, wobei die Störungselemente (20) unregelmäßig, insbesondere im Zickzack, verteilt sind.

8. Solarpaneel nach einem der vorhergehenden Ansprüche, wobei die untere Platte (2) metallisch und derart gestanzt ist, dass sie Störungselemente (20) bildet.

9. Solarpaneel nach einem der vorhergehenden Ansprüche, wobei der Wärmeaustauscher (E) ein einstückiges Teil ist, wobei die untere Platte (2) derart gestaltet ist, dass sie nicht nur die Austauschzone (ZE), sondern auch eine Eintrittszone (ZA) und eine Ableitungszone (ZV) des Kühlmittels bildet.

10. Solarpaneel nach einem der vorhergehenden Ansprüche, wobei die untere Platte (2) derart gestaltet ist, dass sie nicht nur die Austauschzone (ZE), sondern auch den ganzen oder einen Teil des Trägers, auf dem die fotovoltaischen Elemente (1) ruhen, bildet.

11. Solarpaneel nach einem der vorhergehenden Ansprüche, wobei der Wärmeaustauscher (E) Zirkulationskanäle (11, 12) des Kühlmittels, die zu beiden Seiten der Austauschzone (ZE) angeordnet sind, umfasst, wobei die Kanäle Lastverluste haben, die eine homogene Verteilung des Fluids in der Austauschzone sicherstellen.

12. Solarpaneel nach Anspruch 11, wobei die Tiefe der Zirkulationskanäle (11, 12) größer ist als die Stärke der Kühlmittelzunge, die in der Austauschzone (ZE) fließt.

13. Solarpaneel nach einem der Ansprüche 11 oder 12, wobei die untere Platte (2) derart ausgebildet ist, dass sie Zirkulationskanäle (11, 12) bildet.

14. Solarpaneel nach einem der vorhergehenden Ansprüche, wobei die Rückseite des Wärmeaustauschers (E) kein Wärmeisolationsmittel umfasst.

15. Solarpaneel nach einem der vorhergehenden Ansprüche, wobei ein dünnes und langes Verbindungsgehäuse (4) auf der Rückseite des Paneels angeordnet ist, ohne der Rückseite eines fotovoltaischen Elements (1) gegenüberzuliegen.

## Claims

1. Hybrid solar panel comprising:
- photovoltaic elements (1) comprising a front face and a rear face,
- a heat exchanger (E) positioned facing the rear face of the said photovoltaic elements (1),
- a coolant circulating through the said exchanger (E) so as to cool the said photovoltaic elements (1),
- the said exchanger (E) comprising a heat exchange zone (ZE) arranged under the said photovoltaic elements (1) and in which the said fluid flows, the said exchange zone is formed by a bottom plate (2) having perturbation elements (20) perturbing the flow of the said fluid so as to encourage exchanges of heat in the exchange zone (ZE),
- the said inbuilt perturbation elements (20) extending over the entire thickness of the layer of coolant flowing in the said exchange zone,
**characterized in that**
- the bottom plate (2) is a heat exchange plate made of a heat conducting material and shaped in such a way as to form the perturbation elements (20) right from the time of manufacture of the said plate, which elements are produced from the same material as the said plate,
- the upper end of the perturbation elements (20) is in surface contact with the rear face of the photovoltaic elements (1), the surface contact between the upper end of the perturbation elements (20) and the rear face of the photovoltaic elements (1) ensures transmission of heat to the bottom plate (2) so that the coolant captures the heat emanating from the photovoltaic elements (1) not only on the rear face of the said photovoltaic elements but also on the bottom plate (2) so that the said photovoltaic elements are chiefly cooled at these points of contact,
- the perturbation elements (20) form bosses on the top face of the plate (2) over which the coolant flows and form recesses on the underside face of the said plate which is not in contact with the said fluid and which is the opposite face to the said top face.

2. Hybrid solar panel comprising:
- photovoltaic elements (1) comprising a front face and a rear face,
- a heat exchanger (E) positioned facing the rear face of the said photovoltaic elements (1),
- a coolant circulating through the said exchanger (E) so as to cool the said photovoltaic elements (1),
- the said exchanger (E) comprising a heat exchange zone (ZE) arranged under the said photovoltaic elements (1) and in which the said fluid flows, the said exchange zone is formed by a bottom plate (2) having perturbation elements (20) perturbing the flow of the said fluid so as to encourage exchanges of heat in the exchange zone (ZE),
- a top exchange plate (13) is fixed to the rear face of the photovoltaic elements (1),
- the inbuilt perturbation elements (20) extend over the entire thickness of the layer of coolant flowing in the said exchange zone, their upper end being in surface contact with the top exchange plate (13),
**characterized in that**:
- the bottom plate (2) is a heat exchange plate made of a heat conducting material and shaped in such a way as to form the perturbation elements (20) right from the time of manufacture of the said plate, which elements are produced from the same material as the said plate,
- the surface contact between the upper end of the perturbation elements (20) and the top plate (13) ensures that heat is transmitted to the bottom plate (2) so that the coolant captures the heat emanating from the photovoltaic elements not only at the top plate (13) but also at the bottom plate (2) so that the temperature of the said top plate (13) equalizes with no hot spots or cold spots,
- the perturbation elements (20) form bosses on the top face of the plate (2) over which the coolant flows and form recesses on the underside face of the said plate which is not in contact with the said fluid and which is the opposite face to the said top face.

3. Solar panel according to one of the preceding claims, in which the perturbation elements (20) have the form of teats.

4. Solar panel according to one of the preceding claims, in which the perturbation elements (20) have the form of hemispheres.

5. Solar panel according to one of the preceding claims, in which the perturbation elements (20) have the form of cylindrical tubes or polygonal tubes or pyramids.

6. Solar panel one of the preceding claims, comprising several hundred perturbation elements (20) per m² of exchange surface.

7. Solar panel according to one of the preceding claims, in which the perturbation elements (20) are distributed unevenly, notably in a staggered configuration.

8. Solar panel according to one of the preceding claims, in which the bottom plate (2) is made of metal and pressed to form the perturbation elements (20).

9. Solar panel according to one of the preceding claims, in which the heat exchanger (E) is a one-piece component, the bottom plate (2) being configured to form not only the exchange zone (ZE), but also an inlet zone (ZA) and a discharge zone (ZV) for the coolant.

10. Solar panel according to one of the preceding claims, in which the bottom plate (2) is configured to form not only the exchange zone (ZE) but also all or part of the support on which the photovoltaic elements (1) rest.

11. Solar panel according to one of the preceding claims, in which the heat exchanger (E) comprises flow ducts (11, 12) for the coolant these being positioned on each side of the exchange zone (ZE), the said ducts having pressure drops that ensure a uniform distribution of the said fluid in the said exchange zone.

12. Panel according to Claim 11, in which the depth of the flow ducts (11, 12) is greater than the thickness of the layer of coolant flowing in the exchange zone (ZE).

13. Solar panel according to one of Claims 11 and 12, in which the bottom plate (2) is configured to form the flow ducts (11, 12).

14. Solar panel according to one of the preceding claims, in which the rear face of the heat exchanger (E) has no thermal insulation means.

15. Solar panel according to one of the preceding claims, in which a long slender junction box (4) is placed on the rear face of the said panel, without facing the rear face of a photovoltaic element (1).
